(19) Europäisches Patentamt
European Patent Office
Office européen des brevets

(11) **EP 3 655 800 B1**

(12) **FASCICULE DE BREVET EUROPEEN**

(45) Date de publication et mention
de la délivrance du brevet:
**01.09.2021 Bulletin 2021/35**

(21) Numéro de dépôt: **18762356.6**

(22) Date de dépôt: **19.07.2018**

(51) Int Cl.:
*G01V 3/08* *(2006.01)*        *G01V 3/10* *(2006.01)*
*G01P 13/00* *(2006.01)*      *G01C 21/08* *(2006.01)*
*G01R 33/02* *(2006.01)*      *G01V 13/00* *(2006.01)*

(86) Numéro de dépôt international:
**PCT/FR2018/051841**

(87) Numéro de publication internationale:
**WO 2019/016477 (24.01.2019 Gazette 2019/04)**

(54) **PROCÉDÉ ET DISPOSITIF DE MESURE DU CHAMP MAGNÉTIQUE PAR DES MAGNÉTOMÈTRES**

VERFAHREN UND VORRICHTUNG ZUR MAGNETFELDMESSUNG DURCH MAGNETOMETER

METHOD AND DEVICE FOR MAGNETIC FIELD MEASUREMENT BY MAGNETOMETERS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.07.2017 FR 1756974**

(43) Date de publication de la demande:
**27.05.2020 Bulletin 2020/22**

(73) Titulaire: **SYSNAV**
**27200 Vernon (FR)**

(72) Inventeurs:
• **VISSIERE, David**
**75009 Paris (FR)**
• **HILLION, Mathieu**
**27200 Vernon (FR)**

(74) Mandataire: **Regimbeau**
**20, rue de Chazelles**
**75847 Paris Cedex 17 (FR)**

(56) Documents cités:
**EP-A1- 2 311 370        FR-A1- 3 029 642
US-A1- 2010 307 016**

**Description**

## DOMAINE TECHNIQUE GÉNÉRAL ET ART ANTÉRIEUR

La présente invention concerne de façon générale la mesure du champ magnétique par des magnétomètres.

Elle trouve en particulier avantageusement application dans le domaine de la navigation sans GPS, notamment pour l'estimation du mouvement d'un objet par des techniques magnéto-inertielles.

*Généralités*

Les techniques dites de navigation magnéto-inertielles permettent d'estimer précisément la vitesse (et de là, par intégration, la position) d'un solide dans un lieu où le champ magnétique est perturbé.

Notamment, il a été proposé dans le brevet FR2914739 d'utiliser, en complément des équations déjà utilisées en techniques inertielles classiques, l'équation $\dot{B} = -\Omega \wedge B + \nabla B.\ V$ pour estimer le vecteur vitesse (linéaire) $V$, à partir du vecteur vitesse angulaire $\Omega$ (généralement mesuré par des gyromètres de la centrale inertielle), de la mesure d'un champ magnétique $B$, de ses dérivées par rapport au temps $\dot{B}$ et de ses dérivées spatiales $\nabla B$ (gradient), mesurées ou estimées.

Grâce à cette information sur la vitesse du solide, l'erreur sur l'estimation de position sera dans le pire des cas proportionnelle au temps, contrairement aux techniques inertielles classiques où elle est quadratique en temps.

Ces techniques magnéto-inertielles apportent entière satisfaction, et requièrent des capteurs inertiels de moindre performance que les méthodes inertielles classiques (basées sur l'intégration au travers d'un filtre de Kalman ou d'un autre observateur d'informations en provenance de gyromètres et d'accéléromètres embarqués sur le solide dont on souhaite estimer la position et la vitesse : typiquement, les gyromètres « maintiennent » un repère, dans lequel une double intégration temporelle des mesures des accéléromètres permet d'estimer le mouvement) et donc moins encombrants.

Ainsi, par exemple, au moins une centrale inertielle est couplée à un ou plusieurs magnétomètres répartis spatialement (typiquement trois magnétomètres tri-axes disposés sur les sommets d'un trièdre direct) et solidaires de la centrale inertielle (typiquement placée à l'origine du trièdre). Les données issues de ces capteurs sont transmises à une carte électronique d'acquisition et de calcul qui délivre à l'utilisateur l'information de position et de vitesse par résolution de l'équation susmentionnée. L'utilisation de plusieurs magnétomètres permet de mesurer directement les gradients de champ magnétique par exemple par différence finie (développement de Taylor), au lieu de les estimer. On pourra par exemple à cet égard se référer à la demande FR 1653493 de la demanderesse.

Dans ce cas, les informations des magnétomètres sont donc utilisées pour calculer des informations de vitesse linéaire ou de vitesse angulaire.

L'utilisation la plus classique des magnétomètres dans les systèmes embarqués concerne le calcul du cap. Dans ce cas, on fait l'hypothèse que le champ magnétique mesuré par le capteur est le champ magnétique terrestre qui pointe environ vers le nord. L'information d'attitude du système calculée par ailleurs (avec des accéléromètres et des gyromètres par exemple) est utilisée pour déterminer les composantes horizontales My et Mx du champ magnétique.

Le cap psi est alors déterminé comme suit :

$$psi = \operatorname{atan}\left(\frac{My}{Mx}\right)$$

Ce calcul du cap peut être réalisé en même temps que le calcul de l'attitude dans le cadre d'algorithmes AHRS (« *Attitude and Heading Reference System* » selon la terminologie anglosaxonne).

Le calcul du cap peut également être fait en même temps que les techniques de navigation magnéto-inertielles.

EP2311370 A1 divulgue un procédé de détection et un détecteur d'un perturbateur magnétique du champ magnétique émis par un émetteur au moins triaxe de champ magnétique.

*Calibration*

Pour que les calculs réalisés à partir des mesures de champ magnétique (les calculs de cap ou les calculs de navigation magnéto-inertielle) soient justes, il convient d'abord de retirer de la mesure des capteurs magnétiques un maximum d'erreurs intrinsèques. Les erreurs classiquement considérées sont les suivantes : le biais, les facteurs d'échelles, les calages d'axes (erreurs géométriques d'orientation propre de chaque axe capteur).

La suppression des erreurs des capteurs se fait habituellement au moyen d'une calibration du capteur, cette calibration se déroulant en deux phases.

Dans une première phase, on établit- en fonction des erreurs que l'on souhaite calibrer -un modèle dit "de calibration" reliant la mesure brute du capteur $M_B$ à la mesure du capteur calibré $M_C$ (ce que mesurerait le capteur s'il était parfait) et les erreurs capteurs. Par exemple, dans le cas d'une calibration du biais $B$ et du facteur d'échelle matriciel $A$ d'un magnétomètre triaxe, le modèle utilisé peut être le suivant :

$$M_C = A.M_B + B$$

Dans une deuxième phase, on met en œuvre une expérimentation dédiée afin de déterminer les différents paramètres du modèle d'erreur. Dans le cas de l'exemple suscité, il convient d'identifier les différentes composantes de A et de B. De nombreuses méthodes ont déjà été proposées.

Une méthode classique consiste à faire tourner le magnétomètre dans un environnement dépourvu de perturbation du champ magnétique terrestre, de manière à assurer qu'il ne mesure que le champ terrestre $B_T$ qui est de norme constante. On utilise ensuite des méthodes d'optimisation pour identifier A et B de manière à ce que la norme de $M_C$ soit égale à la norme du champ magnétique terrestre. La solution est donc formellement donnée par :

$$\underset{A,B\in M_{3,3}(\mathbb{R})\times M_3(\mathbb{R})}{\arg\min} \left|\left| A.M_B + B \right| - |B_T| \right|$$

On pourra par exemple se référer à l'article suivant :

> "Complete Triaxis Magnetometer Calibration in the Magnetic Domain" - V. Renaudin, M. H. Afzal, and G. Lachapelle - Journal of Sensors - Volume 2010 (2010), Article ID 967245, 10 pages.

D'autres techniques encore peuvent utiliser des machines de calibration permettant de générer un champ magnétique maitrisé. Un exemple en ce sens a notamment été proposé dans l'article :

> "An Automated Indoor Scalar Calibration Method for Three-Axis Vector - Magnetometers" - K.Mohamadabadi, M. Hillion - IEEE Sensors Journal, Institute of Electrical and Electronics Engineers (IEEE), 2014, 14, 3076-3083

Le système qui y est décrit est composé de bobines de Helmholtz triaxiales pilotées en courant de sorte que le champ généré soit de norme constante. L'ensemble est enfermé dans un blindage magnétique isolant le système de l'extérieur, permettant le calcul simultané des biais des capteurs.

*Non linéarités*

Comme tous les capteurs, les magnétomètres connaissent des problèmes de non linéarités.
Le traitement par calibration des erreurs de non linéarités est possible, mais est complexe et non nécessairement totalement fiable.
On comprend en effet que plus le nombre de paramètres à identifier est important, plus l'optimisation devient complexe à faire converger.
En outre, les non linéarités ont un impact sur la mesure plus faible que d'autres paramètres. Typiquement, par exemple, pour des magnétomètres AMR, les biais pourront avoir un impact de l'ordre de 10 à 100mG sur la mesure, tandis que les facteurs d'échelle impacteront la mesure de l'ordre de 1 à 10mG et les non linéarités uniquement de l'ordre de 0.1 à 1mG.

## PRÉSENTATION GÉNÉRALE DE L'INVENTION

Un but général de l'invention est de proposer une technique de mesures par magnétomètres permettant de s'affranchir d'une calibration des non linéarités, tout en offrant une grande précision et une grande fiabilité de mesure.
A cet effet, l'invention propose un procédé de mesure de champ magnétique selon la revendication 1.
Le champ magnétique « candidat » déterminé pour un capteur est par exemple le champ magnétique du capteur ou une combinaison des champs magnétiques de différents capteurs.
Les orientations des directions propres dépendent de chaque magnétomètre.
La répartition des magnétomètres avec un maximum d'orientations différentes dans l'espace permet de trouver toujours un magnétomètre qui a une orientation la plus optimale et d'utiliser sa mesure comme mesure du champ magnétique.
On s'affranchit ainsi des non linéarités des magnétomètres sans avoir à recourir à une calibration spécifique pour traiter les non linéarités.
L'invention propose également un dispositif de mesure de champ magnétique, ainsi qu'un système de navigation magnéto-inertielle.
Elle concerne également un produit programme d'ordinateur comprenant des instructions de code pour l'exécution d'un tel procédé de mesure de champ magnétique, ainsi qu'un moyen de stockage lisible par un équipement informatique sur lequel un produit programme d'ordinateur comprend des instructions de code pour l'exécution d'un tel procédé.

## PRÉSENTATION DES FIGURES

D'autres caractéristiques et avantages de l'invention ressortiront encore de la description qui suit, laquelle est purement illustrative et non limitative, et doit être lue en regard des figures annexées sur lesquelles :

- la figure 1 est un schéma d'équipements pour la mise en œuvre du procédé selon l'invention ;
- la figure 2 représente plus en détail un exemple de boitier pour la mise en œuvre du procédé selon l'invention ;
- la figure 3a illustre une configuration d'un dispositif conforme à un mode de réalisation de l'invention dans laquelle deux magnétomètres sont répartis dans un même plan ;
- la figure 3b illustre une configuration plane avec trois magnétomètres ;

- la figure 4 illustre une configuration avec quatre magnétomètres répartis dans l'espace.

## DESCRIPTION D'UN OU PLUSIEURS MODES DE MISE EN ŒUVRE ET DE RÉALISATION

### Généralités

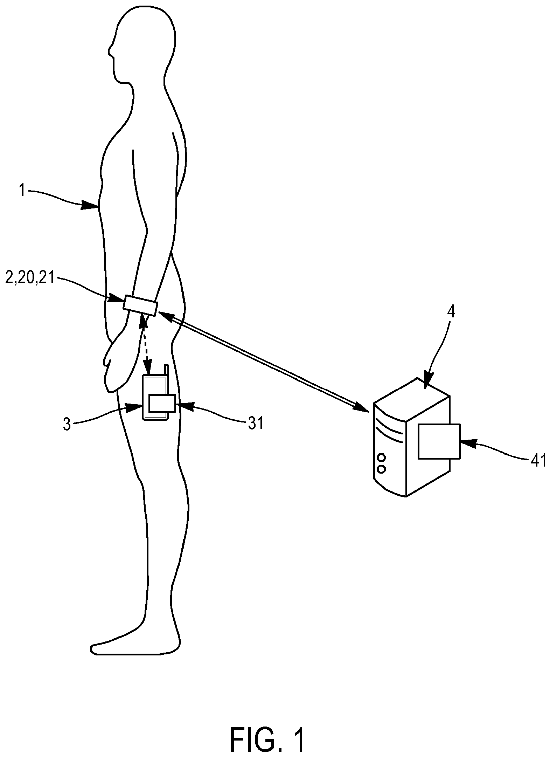

En référence à la figure 1, le dispositif de mesure proposé est par exemple utilisé pour l'estimation du mouvement d'un objet 1 évoluant dans un champ magnétique ambiant (typiquement le champ magnétique terrestre, le cas échéant légèrement altéré par les objets métalliques à proximité), noté $\bar{B}$. Comme on le sait, le champ magnétique est un champ vectoriel tridimensionnel, c'est-à-dire associant un vecteur de dimension trois à chaque point de tridimensionnel dans lequel l'objet est mobile.

Cet objet 1 peut être n'importe quel objet mobile dont la connaissance de la position est souhaitée, par exemple un véhicule à roues, un drone, etc., mais également un piéton.

L'objet 1 est comporte dans un boitier 2 (support) une pluralité de capteurs de mesure magnétique 20, i.e. des magnétomètres axiaux 20. Par magnétomètre axial, on entend un élément capable de mesurer une composante dudit champ magnétique, i.e. la projection dudit vecteur champ magnétique $\bar{B}$ au niveau dudit magnétomètre 20 selon son axe.

Plus précisément, les magnétomètres 20 sont solidaires du boitier 2. Ils présentent un mouvement sensiblement identique au boitier 2 et à l'objet 1 dans le référentiel terrestre.

De façon préférée, le référentiel de l'objet 1 est muni d'un repère cartésien orthonormé dans lequel les magnétomètres 20 présentent une position prédéterminée dans ce repère.

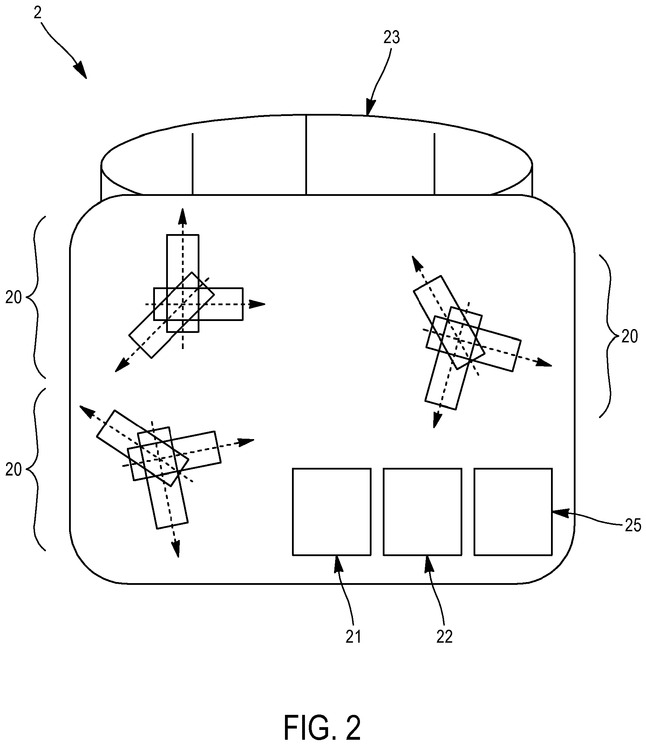

Sur la figure 2, le boitier 2 est fixé sur l'objet 1 (par exemple un membre du piéton) par des moyens d'attache 23. Ces moyens d'attache 23 consistent par exemple en un bracelet par exemple à bande auto-agrippante qui enserre le membre et permet la liaison solidaire.

Bien entendu, l'invention n'est pas limitée à l'estimation du mouvement d'un piéton, mais elle est particulièrement avantageuse dans une telle utilisation car elle permet un encombrement très réduit, ce qui est nécessaire pour que le boitier soit portable par un humain de façon ergonomique.

Le boitier 2 peut comprendre des moyens de traitement 21 (typiquement un processeur) pour la mise en œuvre directement en temps réel des traitements du présent procédé, ou bien les mesures peuvent être émises via des moyens de communication 25 vers un dispositif externe tel qu'un terminal mobile (smartphone) 3, voire un serveur distant 4, ou encore les mesures peuvent être enregistrées dans des moyens de stockage de données 22 locaux (une mémoire par exemple de type flash) mémoire locale pour un traitement a posteriori par exemple sur le serveur 4.

Les moyens de communication 25 peuvent mettre en œuvre une communication sans fil à courte portée par exemple Bluetooth ou Wifi (en particulier dans un mode de réalisation avec un terminal mobile 3) voire être des moyens de connexion à un réseau mobile (typiquement UMTS/LTE) pour une communication à longue distance. Il est à noter que les moyens de communication 25 peuvent être par exemple une connectique filaire (typiquement USB) pour transférer les données des moyens de stockage de données 22 locaux à ceux d'un terminal mobile 3 ou d'un serveur 4.

Si c'est un terminal mobile 3 (respectivement un serveur 4) qui héberge « l'intelligence », il comprend des moyens de traitement 31 (respectivement 41) tels qu'un processeur pour la mise en œuvre des traitements du présent procédé qui vont être décrits. Lorsque les moyens de traitement utilisés sont ceux 21 du boitier 2, celui-ci peut encore inclure des moyens de communication 25 pour transmettre la position estimée. Par exemple la position du porteur peut être envoyée au terminal mobile 3 pour afficher la position dans une interface d'un logiciel de navigation.

Les moyens de traitement de données 21, 31, 41 respectivement du boitier 2, d'un smartphone 3 et d'un serveur distant 4 peuvent indifféremment et selon les applications réaliser tout ou partie des étapes du procédé.

Ils comportent à cet effet chacun des moyens de stockage dans lesquels sont mémorisés tout ou partie de séquences d'instructions de code pour l'exécution du procédé.

### Disposition et orientation des magnétomètres dans l'espace

Chaque capteur magnétomètre, quelle que soit sa structure, présente des directions appelées directions propres dans la suite du texte, pour lequel l'impact des linéarités est minimal.

Les magnétomètres 20 sont disposés dans le boitier 2 de façon à couvrir une multitude d'orientations différentes pour ces directions propres.

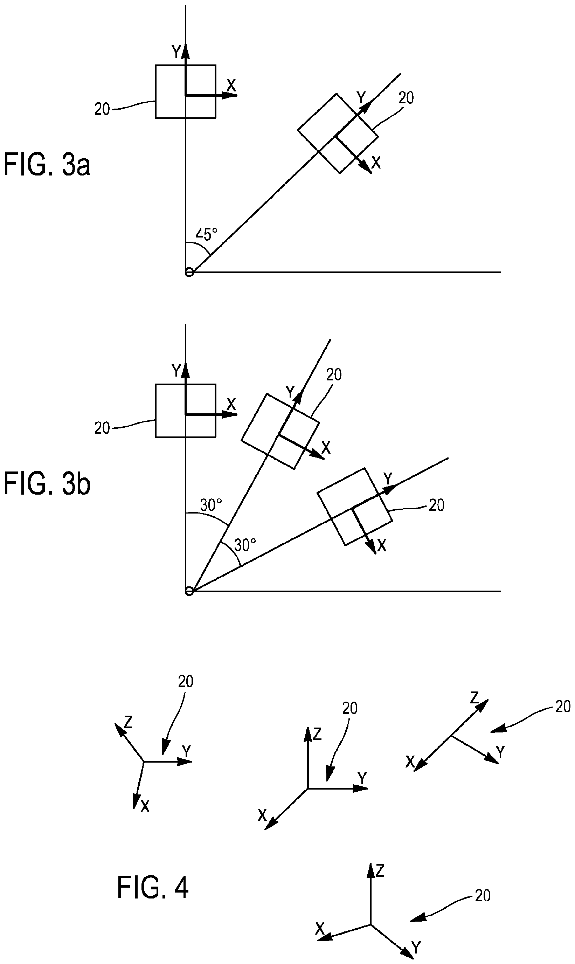

Dans le cas illustré sur les figures 3a et 3b, on a représenté le cas de magnétomètres bi-axiaux 20 présentant chacun deux axes propres X et Y (en l'occurrence perpendiculaires).

Les plans formés par les axes propres X et Y de chacun de ces magnétomètres 20 sont parallèles (coplanaires dans les exemples de ces figures).

Sur la figure 3a, le capteur comporte deux magnétomètres bi-axiaux 20 co-planaires. Ces magnétomètres 20 sont répartis de façon que leurs axes propres soient séparés angulairement de 45°.

On comprend en effet qu'une telle répartition optimise la probabilité qu'un champ magnétique dans le plan XY soit angulairement proche de la direction propre de l'un des capteurs.

Dans le cas illustré sur la figure 3b, le système comporte trois magnétomètres bi-axiaux répartis selon une disposition coplanaire des différents axes propres X et Y des magnétomètres 20. Ces magnétomètres 20 sont orientés de façon que les axes propres de deux magnétomètres successifs soient séparés angulairement de 30°.

On comprend là aussi qu'une telle répartition optimise la probabilité qu'un champ magnétique dans le plan XY soit angulairement proche de la direction propre de l'un des capteurs.

Bien entendu ces deux exemples se généralisent au cas de m magnétomètres bi-axiaux coplanaires ou répartis dans des plans parallèles du dispositif (avec m, nombre entier).

Dans ce cas la répartition optimale est une répartition de magnétomètres séparés par des angles de 90°/m, mais on comprendra bien que l'invention ne se limite pas à cette répartition optimale.

La figure 4 illustre quant à elle le cas de quatre magnétomètres triaxiaux présentant chacun trois axes propres X, Y et Z perpendiculaires. Elle illustre une répartition des orientations de ces quatre magnétomètres dans l'espace qui permet une optimisation de la proximité angulaire entre un champ magnétique B à mesurer et au moins une direction propre de l'un des magnétomètres 20.

De façon plus générale, dans le cas de magnétomètres tri-axes, la répartition de leur orientation est choisie avec un maximum d'orientations dans l'espace afin de maximiser la probabilité de trouver un magnétomètre qui a une orientation la plus optimale (optimisation de la répartition de leur directions propres).

*Choix du magnétomètre pour une mesure donnée*

Pour chaque magnétomètre *j*, on désigne par $\left(\overrightarrow{d_i^j}\right)_{i\in[\![1..n]\!]}$ les *n* directions propres de mesure de ce capteur, c'est-à-dire les directions liées à ce capteur pour lesquelles l'impact des non-linéarités est minimal. Le nombre de ces directions propres dépend du type capteur.

Les moyens de traitement calculent pour chaque magnétomètre un champ magnétique candidat en considérant que les magnétomètres ne sont pas perturbés par les non-linéarités. En effet, comme l'effet des non-linéarités est faible, on peut supposer en première approximation que le champ magnétique fourni par chaque capteur n'est pas trop mauvais, en tout cas, qu'il suffit pour la suite du procédé. Le champ magnétique candidat d'un capteur peut être le champ magnétique mesuré par ce capteur ou une combinaison astucieuse (comme la moyenne par exemple) des champs magnétiques mesurés par tous les capteurs. Dans la suite, on considèrera le cas, plus simple, où le champ magnétique candidat d'un capteur est le champ magnétique mesuré par ledit capteur.

Les moyens de traitement (selon le cas 21, 31 ou 41) calculent pour chaque capteur l'écart d'orientation entre le champ magnétique mesuré par le capteur et ses directions propres. Si $\overrightarrow{B_B^j}$ est le champ magnétique « candidat » pour le capteur *j*, l'écart $e^j$ entre les directions propres et $\overrightarrow{B_B^j}$ est donné par

$$e^j = \min_{i\in[\![1..n]\!]}\left(\overrightarrow{d_i^j}, \overrightarrow{B_B^j}\right)$$

où $\left(\overrightarrow{d_i^j}, \overrightarrow{B_B^j}\right)$ est l'angle entre les deux vecteur $\overrightarrow{d_i^j}$ et $\overrightarrow{B_B^j}$.

Les moyens de traitement 21, 31 ou 41 déterminent ensuite le capteur *j* pour lequel l'écart $e^j$ est minimal.

C'est de ce capteur qu'on obtient la meilleure mesure, au sens où l'impact des non-linéarités est le plus faible sur la mesure.

Le champ magnétique mesuré par le magnétomètre *j* ainsi déterminé est donc retenu par les moyens de traitement 21, 31, 41 comme champ magnétique mesuré par l'ensemble de magnétomètres.

La mesure de champ du magnétomètre j est stockée par lesdits moyens de traitement 21, 31, 41 et/ou utilisée par lesdits moyens de traitement dans les calculs d'informations de navigation magnéto-inertielles (vitesse linéaire, vitesse angulaire, position, cap, etc...).

Dans ces calculs, la mesure du champ j est alors utilisée comme mesure du champ magnétique à l'instant considéré, correspondant à une position / orientation de l'ensemble de magnétomètres.

Les traitements sont alors avantageusement du type de ceux décrits dans le brevet FR2914739 ou dans la demande FR 1653493.

Comme on l'aura compris, le fait d'utiliser le champ magnétique « candidat » du magnétomètre pour lequel l'écart est minimal permet de disposer d'une mesure non perturbée par les non linéarités des magnétomètres et ce sans avoir eu à recourir à une calibration spécifique pour traiter celles-ci.

Bien entendu, le procédé et le dispositif de calibration proposés peuvent être utilisés en combinaisons avec des calibrations destinées à corriger non pas les erreurs de non-linéarité, mais d'autres paramètres d'erreur du capteur selon les méthodes connues.

*Directions propres*

Les directions propres sont déterminées préalablement pour chaque capteur.

Cette détermination peut se faire par exemple à partir de la modélisation des termes d'erreurs du capteur considéré, ou par une analyse de la physique du capteur et/ou de sa mise en œuvre.

On donne ci-après un exemple modélisation et de détermination de directions propres, d'autres modélisations et détermination étant bien entendu possibles.

*Cas des magnétomètres AMR - modélisation des non linéarités*

Les magnétomètres 20 sont par exemple chacun composé de trois puces identiques dont le fonctionnement repose sur la technologie dite AMR (*« Anisotropic Magneto-Resistance »* selon la terminologie anglosaxonne).

Lorsque ces puces sont plongées dans un champ magnétique, elles renvoient une tension qui s'approche d'une fonction affine de la composante du champ magnétique dans la direction de leur axe de sensibilité.

Classiquement, les mesures magnétométriques d'un capteur d'axe de sensibilité X et de plan principal XY (avec Y direction perpendiculaire à X) sont modélisées comme suit (voir par exemple *Handbook of Magnetic Measurements,* S. Tumanski) :

$$M_B^X = \frac{M_C^X}{1 + M_C^Y/H_0}$$

Où $M_B^X$ est le champ magnétique mesuré par le capteur et où $M_C^X$ et $M_C^Y$ sont les champs magnétiques selon les axes X et Y. $H_0$ est le champ rémanent, supposé grand devant les champs magnétiques en jeu.

On peut former un magnétomètre triaxe AMR. Un tel magnétomètre s'analyse comme formé de 3 capteurs mono-axes, dont le modèle de non linéarité est

$$\begin{cases} M_B^X = \dfrac{M_C^X}{1 + M_C^Y/H_0} \\[2mm] M_B^Y = \dfrac{M_C^Y}{1 - M_C^X/H_0} \\[2mm] M_B^Z = \dfrac{M_C^Z}{1 + M_C^Y/H_0} \end{cases}$$

*Cas des magnétomètres AMR -Détermination des directions propres*

En fonction du champ magnétique mesuré, l'impact des non linéarité n'est pas le même sur la mesure du capteur. Ainsi, on lit directement sur le modèle que :

Lorsque le champ est aligné avec les axes capteurs, les non linéarités ne gênent pas la mesure du capteur. En effet :

Si le champ $M_C^X$ est a peu près aligné avec l'axe capteur X, on a $M_C^Y \approx M_C^Z \approx 0$, ce qui donne

$$M_B^X \approx M_C^X$$

$$M_B^Y \approx 0$$

$$M_B^Z \approx 0$$

Si le champ $M_C^Y$ est a peu près aligné avec l'axe capteur Y, on a $M_C^X \approx M_C^Z \approx 0$, ce qui donne

$$M_B^X \approx 0$$

$$M_B^Y \approx M_C^Y$$

$$M_B^Z \approx 0$$

Si le champ $M_C^Z$ est a peu près aligné avec l'axe capteur Z, on a $M_C^X \approx M_C^Y \approx 0$, ce qui donne

$$M_B^X \approx 0$$

$$M_B^Y \approx 0$$

$$M_B^Z \approx M_C^Z$$

Lorsque le champ n'est pas aligné avec les axes capteurs, les non linéarités gênent la mesure du capteur.

Dans le cas d'un champ magnétique orienté à 45° par rapport aux axes X et Y, on a alors

$$M_C^X \approx \frac{\sqrt{2}}{2} M_C$$

$$M_C^Y \approx \frac{\sqrt{2}}{2} M_C$$

$$M_C^Z \approx 0$$

Ce qui donne un champ mesuré

$$\begin{cases} M_B^X = \dfrac{\frac{\sqrt{2}}{2} M_C}{1 + \frac{\sqrt{2}}{2} M_C / H_0} \approx \dfrac{\sqrt{2}}{2} M_C - \dfrac{1}{2} \dfrac{M_C{}^2}{H_0} \\[2em] M_B^Y = \dfrac{\frac{\sqrt{2}}{2} M_C}{1 - \frac{\sqrt{2}}{2} M_C / H_0} \approx \dfrac{\sqrt{2}}{2} M_C + \dfrac{1}{2} \dfrac{M_C{}^2}{H_0} \\[2em] M_B^Z \approx 0 \end{cases}$$

Les directions optimales (axes propres) dans le cas de ce modèle sont donc les axes capteurs.

## Revendications

1. Procédé de mesure de champ magnétique, dans lequel un champ magnétique est mesuré par un ensemble de magnétomètres (20) qui sont liés à un même support mobile (2) et qui présentent des différentes orientations de directions propres par rapport à ce support, dans lequel des moyens de traitement (21) mettent en œuvre, lors d'une mesure dans une position et orientation donnée du support et de l'ensemble de magnétomètres,

   - une détermination, pour chaque magnétomètre d'un champ magnétique « candidat »,
   - une détermination, pour chaque magnétomètre, de l'écart d'orientation entre les directions propres du magnétomètre et le champ magnétique « candidat », **caractérisé en ce que** les moyens de traitement mettent en œuvre en outre
   - une détermination du magnétomètre pour lequel cet écart est minimal, le champ magnétique mesuré par ce capteur étant retenu comme champ magnétique mesuré par l'ensemble de magnétomètres, pour chaque magnétomètre, les moyens de traitement calculant

   $$e^j = \min_{i \in [\![1..n]\!]} \left( \overrightarrow{d_i^j}, \overrightarrow{B_B^j} \right)$$

   où

   - j est un indice désignant le magnétomètre,
   - par $\left( \overrightarrow{d_i^j} \right)_{i \in [\![1..n]\!]}$ les $n$ directions propres de mesure de ce magnétomètre j,

   $\overrightarrow{B_B^j}$ est le champ magnétique « candidat » déterminé pour ledit magnétomètre,

   $\left( \overrightarrow{d_i^j}, \overrightarrow{B_B^j} \right)$ est l'angle entre les deux vecteur $\overrightarrow{d_i^j}$, et $\overrightarrow{B_B^j}$.

2. Procédé selon la revendication 1, dans lequel le champ magnétique « candidat » pour un magnétomètre est le champ magnétique mesuré par ledit magnétomètre.

3. Procédé selon l'une des revendications précédentes, dans lequel les directions propres d'un magnétomètre sont déterminées par modélisation, préalablement aux mesures.

4. Procédé selon l'une des revendications précédentes, dans lequel les moyens de traitement calculent des informations de navigation magnétiques en utilisant le champ magnétique mesuré par le magnétomètre pour lequel l'écart aux directions propres est minimal, comme mesure du champ magnétique de l'ensemble de magnétomètres.

5. Dispositif de mesure de champ magnétique comportant un support mobile (2) et un ensemble de magnétomètres (20) liés audit support, lesdits magnétomètres présentant différentes orientations de direction propres dans celui-ci, ledit dispositif comportant en outre des moyens de traitement (21) adaptés pour mettre en œuvre, lors d'une mesure dans une position et orientation donnée de l'ensemble de magnétomètres,

   - une détermination, pour chaque magnétomètre d'un champ magnétique « candidat »,
   - une détermination, pour chaque magnétomètre, de l'écart d'orientation entre les directions propres du magnétomètre et le champ magnétique « candidat », **caractérisé en ce que** les moyens de traitement sont adaptés pour mettre en œuvre en outre
   - une détermination du magnétomètre pour lequel cet écart est minimal, le champ magnétique mesuré par ce capteur étant retenu comme champ magnétique mesuré par l'ensemble de magnétomètres, pour chaque magnétomètre, les moyens de traitement calculant

   $$e^j = \min_{i \in [\![1..n]\!]} \left( \overrightarrow{d_i^j}, \overrightarrow{B_B^j} \right)$$

où

- j est un indice désignant le magnétomètre,

- par $\left(\overrightarrow{d_i^j}\right)_{i\in\llbracket 1..n\rrbracket}$ les *n* directions propres de mesure de ce magnétomètre j,

- $\overrightarrow{B_B^j}$ est le champ magnétique « candidat » déterminé pour ledit magnétomètre,

$\left(\overrightarrow{d_i^j}, \overrightarrow{B_B^j}\right)$ est l'angle entre les deux vecteur $\overrightarrow{d_i^j}$, et $\overrightarrow{B_B^j}$.

6. Dispositif selon la revendication 5, comportant une pluralité de magnétomètres plans à deux axes propres, ces magnétomètres étant parallèles, leurs orientations étant réparties pour que les directions de leurs axes propres soient séparées angulairement d'un angle de 90°/m, ou m est le nombre de ces magnétomètres.

7. Dispositif selon la revendication 5, dans lequel lesdits magnétomètres sont parallèles.

8. Dispositif selon la revendication 5, dans lequel les magnétomètres sont de type tri-axes, les orientations de ces magnétomètres étant répartis afin d'optimiser la répartition de leurs directions propres dans l'espace.

9. Système de navigation comportant au moins un dispositif de mesure de champ magnétique selon l'une des revendications 5 à 8.

10. Produit programme d'ordinateur comprenant des instructions de code pour l'exécution d'un procédé de mesure de champ magnétique selon l'une des revendications 1 à 4, lorsque ledit programme est exécuté sur un ordinateur.

11. Moyen de stockage lisible par un équipement informatique sur lequel un produit programme d'ordinateur comprend des instructions de code pour l'exécution d'un procédé de mesure de champ magnétique selon l'une des revendications 1 à 4.

**Patentansprüche**

1. Magnetfeld-Messverfahren, bei dem ein Magnetfeld durch eine Gruppe von Magnetometern (20) gemessen wird, die mit einem und demselben mobilen Träger (2) verbunden sind und der die unterschiedlichen Richtungsausrichtungen aufweisen, die in Bezug auf diesen Träger typisch sind, bei dem die Verarbeitungsmittel (21) bei einer Messung in einer bestimmten Position und Ausrichtung des Trägers und der Gruppe von Magnetometern umsetzen,

- eine Bestimmung eines "Kandidaten"-Magnetfeldes für jeden Magnetometer,
- eine Bestimmung der Ausrichtungsabweichung zwischen den typischen Richtungen des Magnetometers und dem "Kandidaten"-Magnetfeld für jeden Magnetometer, **dadurch gekennzeichnet, dass** die Verarbeitungsmittel umsetzen
- eine Bestimmung des Magnetometers, für das diese Abweichung minimal ist, wobei das von diesem Sensor gemessene Magnetfeld als von allen Magnetometern gemessenes Magnetfeld für jeden Magnetometer festgehalten wird, wobei die Verarbeitungsmittel berechnen

$$e^j = \min_{i\in\llbracket 1..n\rrbracket}\left(\overrightarrow{d_i^j}, \overrightarrow{B_B^j}\right)$$

wobei

- J ein den Magnetometer angebender Index ist,
- $\left(\overrightarrow{d_i^j}\right)_{i\in\llbracket 1..n\rrbracket}$ die n typischen Messrichtungen dieses Magnetometers j,
- $\overrightarrow{B_B^j}$ das "Kandidaten"-Magnetfeld ist, das für den genannten Magnetometer bestimmt wird

$\left(\overrightarrow{d_i^j}, \overrightarrow{B_B^j}\right)$ der Winkel zwischen den zwei Vektoren $\overrightarrow{d_i^j}$, und $\overrightarrow{B_B^j}$ ist.

2. Verfahren gemäß Anspruch 1, bei dem das "Kandidaten"-Magnetfeld für einen Magnetometer das Magnetfeld ist, das von dem genannten Magnetometer gemessen wird.

3. Verfahren gemäß einem der voranstehenden Ansprüche, bei dem die typischen Richtungen eines Magnetometers per Modellgestaltung vor den Messungen bestimmt werden.

4. Verfahren gemäß einem der voranstehenden Ansprüche, bei dem die Verarbeitungsmittel magnetische Navigationsinformationen unter Verwendung des Magnetfeldes, das von dem Magnetometer gemessen wird, für das die Abweichung von den typischen Richtungen minimal ist, als Messung des Magnetfeldes der Gruppe von Magnetometern berechnen.

5. Magnetfeld-Messvorrichtung, umfassend einen mobilen Träger (2) und eine Gruppe von mit dem genannten Träger verbundenen Magnetometern (20), wobei die genannten Magnetometer unterschiedliche Ausrichtungen typischer Richtungen in demselben aufweisen, wobei die genannte Vorrichtung darüber hinaus Verarbeitungsmittel (21) umfasst, die geeignet sind, um bei einer Messung in einer bestimmten Position und Ausrichtung der Gruppe von Magnetometern umzusetzen

- eine Bestimmung eines "Kandidaten"-Magnetfeldes für jeden Magnetometer,
- eine Bestimmung der Ausrichtungsabweichung zwischen den typischen Richtungen des Magnetometers und dem "Kandidaten"-Magnetfeld für jeden Magnetometer, **dadurch gekennzeichnet, dass** die Verarbeitungsmittel geeignet sind, um darüber hinaus umzusetzen,
- eine Bestimmung des Magnetometers, für den diese Abweichung minimal ist, wobei das von diesem Sensor gemessene Magnetfeld als Magnetfeld für jeden Magnetometer festgehalten wird, das von allen Magnetometern gemessen wird, wobei die Verarbeitungsmittel berechnen

$$e^j = \min_{i \in [\![1..n]\!]} \left( \overrightarrow{d_i^j}, \overrightarrow{B_B^j} \right)$$

wobei

- j ein den Magnetometer bezeichnender Index ist,
- $\left( \overrightarrow{d_i^j} \right)_{i \in [\![1..n]\!]}$ die n typischen Messrichtungen dieses Magnetometers j,
- $\overrightarrow{B_B^j}$ das "Kandidaten"-Magnetfeld ist, das für den genannten Magnetometer bestimmt wird

$\left( \overrightarrow{d_i^j}, \overrightarrow{B_B^j} \right)$ der Winkel zwischen den zwei Vektoren $\overrightarrow{d_i^j}$, und $\overrightarrow{B_B^j}$ ist.

6. Vorrichtung gemäß Anspruch 5, umfassend eine Vielzahl von ebenen Magnetometern mit zwei typischen Achsen, wobei diese Magnetometer parallel sind, wobei ihre Ausrichtungen verteilt sind, damit die Richtungen ihrer typischen Achsen winkelförmig um einen Winkel von 90 °/m getrennt sind, wobei m die Anzahl dieser Magnetometer ist.

7. Vorrichtung gemäß Anspruch 5, bei der die genannten Magnetometer parallel sind.

8. Vorrichtung gemäß Anspruch 5, bei der die Magnetometer vom dreiachsigen Typ sind, wobei die Ausrichtungen dieser Magnetometer verteilt sind, um die Verteilung ihrer typischen Richtungen im Raum zu optimieren.

9. Navigationssystem, umfassend wenigstens eine Magnetfeld-Messvorrichtung gemäß einem der Ansprüche 5 bis 8.

10. Computerprogramm-Produkt, umfassend Codeanweisungen für die Ausführung eines Magnetfeld-Messverfahrens gemäß einem der Ansprüche 1 bis 4, wenn das genannte Programm auf einem Computer ausgeführt ist.

11. Speichermittel, das auf einer Informatikausrüstung lesbar ist, auf der ein Computerprogramm-Produkt Codeanweisungen für die Ausführung eines Magnetfeld-Messverfahrens gemäß einem der Ansprüche 1 bis 4 umfasst.

**Claims**

1. Method for measuring a magnetic field, in which a magnetic field is measured by a set of magnetometers (20) which are linked to a same moveable support (2) and which have different orientations of eigendirections with respect to this support, wherein processing means (21) implement, during a measurement in a given position and orientation of the support and of the set of magnetometers,

- a determination, for each magnetometer of a "candidate" magnetic field,
- a determination, for each magnetometer, of the orientation deviation between the eigendirections of the magnetometer and the "candidate" magnetic field, **characterised in that** the processing means further implement
- a determination of the magnetometer for which this deviation is minimal, the magnetic field measured by this sensor being selected as the magnetic field measured by the set of magnetometers, for each magnetometer, the processing means calculating

$$e^j = \min_{i \in [\![1..n]\!]} \left( \overrightarrow{d_i^j}, \overrightarrow{B_B^j} \right)$$

where

- j is an index designating the magnetometer,

$\left(\overrightarrow{d_i^j}\right)_{i\in[\![1..n]\!]}$ the $n$ measurement eigendirections of this magnetometer j,

- $\overrightarrow{B_B^j}$ is the "candidate" magnetic field determined for said magnetometer,

$\left(\overrightarrow{d_i^j}, \overrightarrow{B_B^j}\right)$ is the angle between the two vectors $\overrightarrow{d_i^j}$, and $\overrightarrow{B_B^j}$.

2. Method according to claim 1, in which the "candidate" magnetic field for a magnetometer is the magnetic field measured by said magnetometer.

3. Method according to one of the preceding claims, in which the eigendirections of a magnetometer are determined by modelling, prior to the measurements.

4. Method according to one of the preceding claims, in which the processing means calculate magnetic navigation information using the magnetic field measured by the magnetometer for which the deviation from the eigendirections is minimal as measurement of the magnetic field of the set of magnetometers.

5. Device for measuring a magnetic field comprising a moveable support (2) and a set of magnetometers (20) linked to said support, said magnetometers having different orientations of eigendirections therein, said device further comprising processing means (21) suited to implementing, during a measurement in a given position and orientation of the set of magnetometers,

 - a determination, for each magnetometer, of a "candidate" magnetic field,
 - a determination, for each magnetometer, of the orientation deviation between the eigendirections of the magnetometer and the "candidate" magnetic field, **characterised in that** the processing means are adapted to further implement
 - a determination of the magnetometer for which this deviation is minimal, the magnetic field measured by this sensor being selected as the magnetic field measured by the set of magnetometers, for each magnetometer, the processing means calculating

$$e^j = \min_{i\in[\![1..n]\!]} \left(\overrightarrow{d_i^j}, \overrightarrow{B_B^j}\right)$$

where

 - j is an index designating the magnetometer,

 - $\left(\overrightarrow{d_i^j}\right)_{i\in[\![1..n]\!]}$ the $n$ measurement eigendirections of this magnetometer j,

 - $\overrightarrow{B_B^j}$ is the "candidate" magnetic field determined for said magnetometer,

$\left(\overrightarrow{d_i^j}, \overrightarrow{B_B^j}\right)$ is the angle between the two vectors $\overrightarrow{d_i^j}$, and $\overrightarrow{B_B^j}$.

6. Device according to claim 5, comprising a plurality of flat magnetometers with two eigenaxes, these magnetometers being parallel, their orientations being distributed so that the directions of their eigenaxes are separated angularly by an angle of 90°/m, where m is the number of these magnetometers.

7. Device according to claim 5, in which said magnetometers are parallel.

8. Device according to claim 5, in which the magnetometers are of triaxial type, the orientations of these magnetometers being distributed in order to optimise the distribution of their eigendirections in space.

9. Navigation system comprising at least one magnetic field measurement device according to one of claims 5 to 8.

10. Computer programme product including code instructions for the execution of a magnetic field measurement method according to one of claims 1 to 4, when said programme is executed on a computer.

11. Storage means readable by a computer equipment on which a computer programme product includes code instructions for the execution of a magnetic field measurement method according to one of claims 1 to 4.

FIG. 1

FIG. 2

FIG. 3a

FIG. 3b

FIG. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2914739
- FR 1653493
- EP 2311370 A1

**Littérature non-brevet citée dans la description**

- **V. RENAUDIN ; M. H. AFZAL ; G. LACHAPELLE.** Complete Triaxis Magnetometer Calibration in the Magnetic Domain. *Journal of Sensors,* 2010, vol. 2010, 10
- An Automated Indoor Scalar Calibration Method for Three-Axis Vector - Magnetometers. **K.MOHAMADABADI ; M. HILLION.** IEEE Sensors Journal. Institute of Electrical and Electronics Engineers (IEEE), 2014, vol. 14, 3076-3083